# EUROPEAN PATENT APPLICATION

(11) **EP 1 081 751 A2**
(43) Date of publication of application: **07.03.2001**
(21) Application number: 00307537.1
(22) Date of filing: 01.09.2000
(51) Int. Cl.: H01L 21/285

(54) **Methods of pre-cleaning dielectric layers of substrates**

(30) Priority: 02.09.1999 US 388989; 02.09.1999 US 388991
(71) Applicant: Applied Materials, Inc., Santa Clara, California 95054 (US)
(72) Inventor: Cohen, Barney M., Santa Clara California 95051 (US); Rengarajan, Suraj, San Jose California 95129 (US); Li, Xiangbing, San Jose California 95120 (US); Ngan, Kenny King-Tai, Fremont California 94539 (US); Ding, Peijun, San Jose California 95129 (US)
(74) Representative: Bayliss, Geoffrey Cyril

(57) **Abstract**

The disclosure relates to a method for improving fill and electrical performance of metals deposited on patterned dielectric layers. Apertures such as bias and trenches in the patterned dielectric layer are etched to enhance filling and then cleaned in the same chamber to reduce metal oxides within the aperture. The patterned dielectric is cleaned in a processing chamber (20) with a first plasma consisting essentially of argon (212) wherein the first plasma is generated by supplying power to a coil surrounding the processing chamber and supplying bias to a substrate support member supporting the substrate, the patterned dielectric layer is cleaned in the processing chamber with a second plasma consisting essentially of hydrogen and helium (215) wherein the second plasma is generated by increasing the supply of power to the coil surrounding the processing chamber and reducing the supply of bias to the substrate support member supporting the substrate, a barrier layer is deposited on the patterned dielectric layer after exposing the dielectric layer to the first plasma and the second plasma (220) and a metal is deposited on the barrier layer (225). Furthermore, the sequential plasma treatments can be practised in a variety of plasma processing chambers of an integrated process sequence, including pre-clean chambers, physical vapor deposition chambers, etch chambers, and other plasma processing chambers. The pre-clean process can also repair damage to the dielectric caused by preceding process steps, such a oxygen plasma ashing processes for removing photoresist.

## Description

The present invention generally relates to deposition of films onto a substrate. More particularly, the present invention relates to etching and cleaning of dielectric layers prior to metal deposition.

As feature sizes have become smaller and multilevel metallization commonplace in integrated circuits, low dielectric constant films have become increasingly important. Low dielectric constant films are particularly desirable for intermetal dielectric (IMD) layers to reduce the RC time delay of the interconnect metallization being covered, to prevent crosstalk between the different levels of metallization, and to reduce device power consumption.

Sub-half micron multilevel metallization is one of the key technologies for the next generation of very large scale integration ("VLSI"). The multilevel interconnects that lie at the heart of this technology require planarization of high aspect ratio features such as plugs and other interconnects. Reliable formation of these interconnects is very important to the success of VLSI and to the continued effort to increase circuit density and quality on individual substrates and die.

Conventional chemical vapor deposition (CVD) and physical vapor deposition (PVD) techniques are used to deposit electrically conductive material into the contact holes, vias, trenches, or other features formed on the substrate. One problem with conventional processes arises because the contact holes or other patterns often comprise high aspect ratios, i.e., the ratio of the height of the holes to their width or diameter is greater than 1. The aspect ratio of the holes increases as advances in technology yield more closely spaced features.

The presence of native oxides and other contaminants within a small feature typically results in voids in the metal deposited in the features as the native oxides and other contaminants promote uneven distribution of the depositing metal. The native oxide typically forms as a result of exposing the exposed film layer/substrate to oxygen. Oxygen exposure occurs when moving substrates in air between processing chambers at atmospheric conditions, or when a small amount of oxygen remaining in a vacuum chamber contacts the wafer/film layer, or when a layer is contaminated by etching. Other contaminants within the features can be sputtered material from an oxide over-etch, residual photoresist from a stripping process, leftover hydrocarbon or fluorinated hydrocarbon polymers from a previous oxide etch step, or re-deposited material from a pre-clean sputter etch process. The native oxide and other contaminants create regions on the substrate which interfere with film formation, by creating regions where film growth is stunted. Regions of increased growth merge and seal the small features before regions of limited growth can be filled with the depositing metal.

The presence of native oxides and other contaminants also can increase the via/contact resistance and can reduce the electromigration resistance of small features. The contaminants can diffuse into the dielectric layer, the sub-layer, or the deposited metal and alter the performance of devices which include the small features. Although contamination may be limited to a thin boundary region within the features at the interface of the deposited metal and an underlying conductive or semi-conductive feature, the thin boundary region is a substantial part of the small features. The acceptable level of contaminants in the features decreases as the features become smaller in width.

Pre-cleaning of features using sputter etch processes is effective for reducing contaminants in large features or in small features having aspect ratios smaller than about 4:1. However, sputter etch processes can damage silicon layers by physical bombardment, sputter deposition of Si/SiO₂ onto sidewalls of the features, and sputter deposition of metal sub-layers, such as aluminum, onto sidewalls of the features. For larger features, the sputter etch processes typically reduce the amount of contaminants within the features to acceptable levels. For small features having larger aspect ratios, sputter etch processes have not been as effective in removing contaminants within the features, thereby compromising the performance of the devices which are formed.

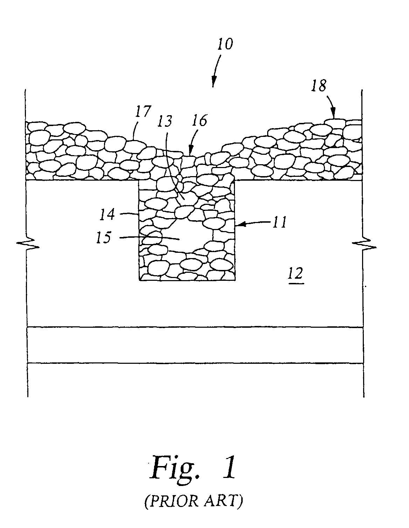

Referring to Figure 1, a substrate 10 including a hole 11 formed within an electrically insulative or dielectric layer 12 thereon, such as for example, a silicon dioxide or silicon nitride layer is shown. It is difficult to deposit a uniform metal-containing layer into the high aspect ratio hole 11 because contaminants on the sidewalls 14 of the holes promote uneven deposition of the metal containing layer. The metal containing layer eventually converges across the width of the hole before it is completely filled, thus forming voids and discontinuities within the hole. Thereafter, the high mobility of metal atoms surrounding the voids causes the atoms to diffuse and minimize the surface area of the voids forming circular shaped voids as shown in Figure 1. These voids and discontinuities result in poor and unreliable electrical contacts.

Pre-cleaning is primarily a sputter etch type process, wherein contaminants are sputtered from the substrate. It is preferably conducted with a mixture of an inert gas, typically argon, and a reactive gas, typically hydrogen. Mixtures of argon and hydrogen remove both reactive and non-reactive contaminants and can be used to modify the shape of contact holes, vias, trenches and other patterns to improve subsequent metal deposition processes. Increasing the argon content in the pre-clean mixture provides a corresponding increase in the etch rate of the pre-clean process and a corresponding decrease in the etch uniformity of the pre-clean process. Hydrogen must be included in the mixture to effectively remove reactive compounds or contaminants such as hydrocarbons. Pre-cleaning patterned substrates with a mixture of argon and any amount of hydrogen provides a lower etch rate and an increased etch non-uniformity than pre-cleaning with argon.

A pre-clean process having both high concentrations of reactive gases and improved etch rates would substantially promote removal of contaminants by addition of the reactive gases.

U.S. Patent No. 5,660,682, by *Zhao et al,* illustrates an attempt to combine etching and reactive cleaning of patterned dielectric layers using a plasma comprising hydrogen and argon. The argon etches deposits from apertures and the hydrogen reacts with remaining deposits to form gaseous byproducts. The combination of etching and cleaning does improve subsequent deposition of metals, however, the combined plasma processing does not prevent formation of voids in subsequent metal layers. Therefore, there remains a need for a method to improve deposition of metal layers on a patterned dielectric layer, especially apertures such as vias and trenches having an aspect ratio greater than about 1.0.

The present invention generally provides a method for improving fill and electrical performance of metals deposited on patterned dielectric layers. Apertures such as vias and trenches in the patterned dielectric layer are etched to enhance filling and then cleaned to reduce metal oxides within the aperture.

The invention also provides a process for cleaning a patterned dielectric layer in a processing chamber using a first plasma consisting essentially of argon, wherein the first plasma is generated by supplying RF plasma power to an inductive coil surrounding the processing chamber and by supplying RF bias to a substrate support member supporting the substrate. The patterned dielectric layer is cleaned in the processing chamber with a second plasma consisting essentially of hydrogen and helium, wherein the second plasma is generated by increasing the supply of RF plasma power to the inductive coil surrounding the processing chamber and reducing the supply of RF bias to the substrate support member supporting the substrate.

A barrier/liner layer may then be deposited on the patterned dielectric layer after exposing the dielectric layer to the first plasma and the second plasma, after which a metal layer may be deposited on the barrier layer. Furthermore, the sequential plasma treatments can be practiced in a variety of plasma processing chambers of an integrated process sequence, including pre-clean chambers, physical vapor deposition chambers, etch chambers, and other plasma processing chambers.

The invention includes a pre-cleaning process suitable for fabricating metal plugs in a low-K, carbon-containing dielectric. More specifically, the invention is a process for cleaning a contact area of a metal conductor on a semiconductor workpiece so as to minimize damage to a carbon-containing dielectric overlying the metal. After forming contact openings in the dielectric so as to expose contact areas on the underlying metal conductor, the contact areas are cleaned by exposing the workpiece to a plasma formed from a mixture of hydrogen-containing and helium gases.

Surprisingly, the hydrogen-helium plasma process can repair damage to the dielectric caused by preceding process steps. Accordingly, another aspect of the invention is a method of using such plasma process to repair damage to a carbon-containing dielectric on a semiconductor workpiece caused by an oxygen plasma process for stripping resist from the surface of the dielectric.

So that the manner in which the above recited features, advantages and objects of the present invention are attained and can be understood in detail, a more particular description of the invention, briefly summarized above, may be had by reference to the embodiments thereof which are illustrated in the appended drawings.

It is to be noted, however, that the appended drawings illustrate only typical embodiments of this invention and are therefore not to be considered limiting of its scope, for the invention may admit to other equally effective embodiments.
Figure 1 is a schematic partial sectional view of a patterned substrate showing a randomly-oriented, fine-grained, granular deposition layer in a contact hole in the substrate with voids, discontinuities and a non-planar surface;
Figure 2 is a schematic view of a cluster tool system having multiple substrate processing chambers;
Figure 3 is a flowchart showing a sequential argon plasma cleaning and hydrogen plasma cleaning steps of the present invention along with other process sequence steps that occur before and after the argon and hydrogen plasma steps;
Figure 4 is a cross sectional view of a typical PVD chamber useful for depositing a barrier layer;
Figure 5 is a cross sectional view of a typical pre-clean chamber useful for the present invention;
Figure 6 is a sectional view of a semiconductor workpiece on which the processes of the invention may be performed;
Figure 7 is a flow chart of a photoresist ashing process and pre-clean process according to our invention; and
Figure 8 is a partially schematic, sectional view of a plasma chamber suitable for performing the pre-clean process of the invention.

The invention provides a suitable method for pre-cleaning vias, contacts, and other features etched into a dielectric layer, such as a silicon dioxide layer that is etched in a dry or wet etch chamber, to expose a conductive or semi-conductive sub-layer, such as Ge, Si, Al, Cu, or TiN sub-layers. The etch exposes the sub-layer so that the feature can be filled with a conductive or semi-conductive material which connects the sub-layer and a subsequent metal interconnect layer to be deposited on the dielectric layer. Etching of the features in the dielectric typically leaves contaminants which should be removed to improve filling of the features and ultimately improve the integrity and reliability of the devices formed.

Pre-clean by a sputter etch process is unsuitable for features with exposed metals, and is particularly unsuitable for features with exposed copper. Copper easily diffuses through dielectrics, including sidewalls of vias formed in dielectrics, destroying or compromising the integrity of the dielectric. This diffusion is especially true for TEOS, thermal oxide and some low K dielectric materials.

In one aspect, the invention provides cleaning of the patterned dielectric layer in a processing chamber with a first plasma comprising predominantly argon, and cleaning the patterned dielectric layer in the processing chamber with a second plasma consisting essentially of hydrogen and helium. After etching and cleaning, the apertures are filled with a metal which may be deposited on a barrier/liner layer. Preferably, both cleaning processes are performed in the same chamber.

After etching of the dielectric layer, the features can have damaged silicon or metal residues within the features from over-etching of the dielectric layer. The features can also contain residual photoresist on the feature surfaces from the photoresist stripping and/or ashing process or residual hydrocarbon or fluorinated hydrocarbon polymers from the dielectric etch step. The feature surfaces may also contain re-deposited material generated by a sputter etch pre-clean process. These contaminants can migrate into the dielectric layer or can interfere with the selectivity of metallization by promoting uneven distribution of the depositing metal. The presence of the contaminants also can increase the resistance of the deposited metal by substantially narrowing the width of the feature, and thus creating a narrowed portion in the metal forming the via, contact line, or other conductive feature.

The submicron features that are cleaned and filled in accordance with the present invention, are formed by conventional techniques which deposit a dielectric material over a surface on a semiconductor substrate. Any dielectric material, whether presently known or yet to be discovered, may be used and is within the scope of the present invention, including low dielectric materials such as organic polymers and aerogels. The dielectric layer may comprise one or more distinct layers and may be deposited on any suitable deposition enhancing sub-layer. The preferred deposition enhancing sub-layers include conductive metals such as Al and Cu, and barrier surfaces such as TiN, Ta, and TaN.

Once deposited, the dielectric layer is etched by conventional techniques to form vias, contacts, trenches or other submicron features. The features will typically have a high aspect ratio with steep sidewalls. Etching of the dielectric layer may be accomplished with any dielectric etching process, including plasma etching. Specific techniques for etching silicon dioxide include such compounds as C2F6, SF6, and NF3. However, patterning may be accomplished on any layer using any method known in the art.

### DETAILED DESCRIPTION OF A PREFERRED EMBODIMENT

### I. Pre-Cleaning Using an Argon Plasma and Then a Hydrogen Plasma

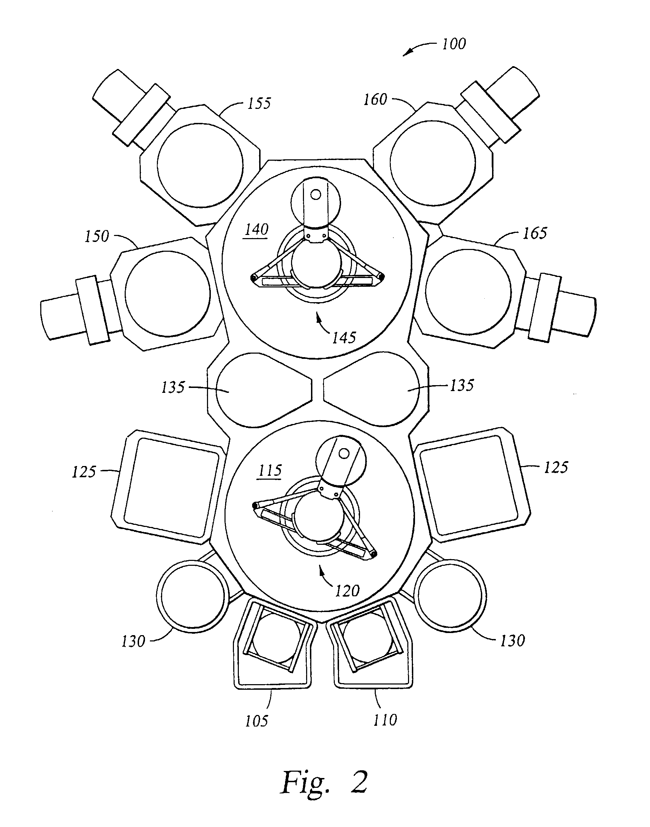

Figure 2 is a schematic view of a cluster tool system having multiple substrate processing chambers. The cluster tool system 100 includes vacuum load-lock chambers 105, 110 attached to a first stage transfer chamber 115. The load-lock chambers 105, 110 maintain vacuum conditions within the first stage transfer chamber 115 while substrates enter and exit system 100. A first robot 120 transfers substrates between the load-lock chambers 105, 110 and one or more substrate processing chambers 125 and 130 attached to the first stage transfer chamber 115. Processing chambers 125, 130 can be outfitted to perform a number of substrate processing operations such as chemical vapor deposition (CVD), physical vapor deposition (PVD), etch, pre-clean, degas, orientation and other substrate processes. The first robot 120 also transfers substrates to/from one or more transfer chambers 135 disposed between the first stage transfer chamber 115 and a second stage transfer chamber 140. The transfer chambers 135 are used to maintain ultrahigh vacuum conditions in the second stage transfer chamber 140 while allowing substrates to be transferred between the first stage transfer chamber 115 and the second stage transfer chamber 140. A second robot 145 transfers substrates between the transfer chambers 135 and a plurality of substrate processing chambers 150, 155, 160 and 165.

Similar to the processing chambers 125, 130 described above, the additional processing chambers 150, 165 can be outfitted to perform a variety of substrate processing operations. For example, the processing chamber 150 is a CVD chamber outfitted to deposit a silicon oxide film; the processing chamber 155 is an etching chamber outfitted to etch apertures or opening for interconnect features; the processing chamber 160 is a PVD chamber outfitted to reactively sputter deposit a barrier film such as tantalum and/or tantalum nitride; and the processing chamber 165 is a PVD chamber outfitted to sputter deposit a conductive film, such as copper. The above listed sequence arrangement of the processing chambers is useful for practicing the present invention. A plurality of cluster tool systems may be required to perform all of the processes required to complete the interconnect portion of the manufacture of an integrated circuit or chip.

During operation, substrates are brought to vacuum load-lock chambers 105, 110 by a conveyor belt or robot system (not shown) that operates under the control of a computer program executed by a microprocessor or computer (not shown). Also, the robots 120 and 145 operate under control of the computer program to transfer substrates between the various processing chambers of the cluster tool system 100.

The above-described cluster tool system is mainly for illustrative purposes. Other plasma processing equipment, such as electron cyclotron resonance (ECR) plasma processing devices, induction-coupled RF high-density plasma processing devices or the like may be employed as part of the cluster tool system. Additionally, the method for forming a silicon oxide layer and barrier layer of the present invention is not limited to any specific apparatus or to any specific plasma excitation method.

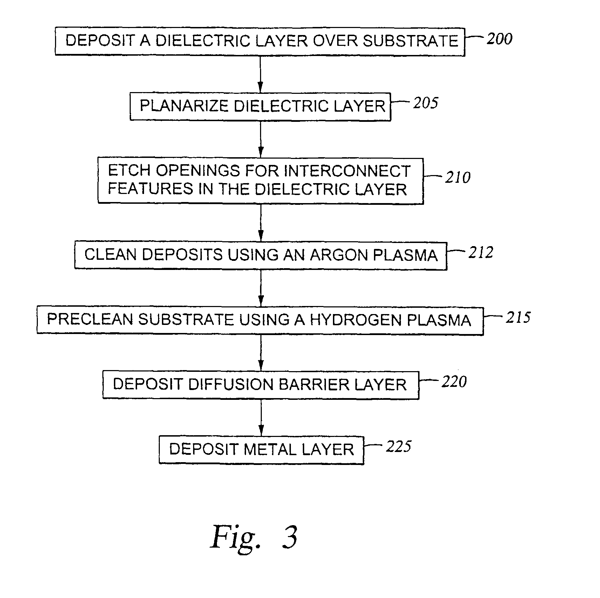

Figure 3 is a flowchart showing an argon pre-cleaning step and a hydrogen plasma pre-cleaning step of the present invention along with other process sequence steps that occur before and after the hydrogen plasma pre-cleaning step. The steps shown in Figure 3 can be executed in response to instructions of a computer program executed by a microprocessor or computer controller for the cluster tool system 100.

First, a dielectric layer is deposited over a substrate (step 200). The deposition of dielectric layers such as silicon oxide films can be accomplished through a variety of methods well known in the art. Preferably, the dielectric layer is deposited using a chemical vapor deposition process performed, for example, in the CVD chamber 150 as shown in Figure 2. Before deposition of the dielectric layer, however, the substrate is typically subjected to multiple processing steps to form active devices and other structures as understood by a person of ordinary skill in the art.

Second, the dielectric layer may be planarized (step 205) in preparation for deposition of overlying layers. The planarization process can include chemical mechanical polishing (CMP), etching or other similar processes. Openings or apertures for interconnect features, such as contacts and vias, are etched in the dielectric layer (step 210). The etch processes can be carried out in a typical etch chamber, such as the etch chamber 155 as shown in the cluster tool system 100 of Figure 2. Typically, the dielectric layer is between about 0.5 microns and about 3.0 microns thick, and the interconnect features have sub-quarter micron openings and aspect ratios (ratio of width to height) greater than 1:1. Steps 205 and 210 produces a patterned substrate having interconnect features to be metallized or filled with layers of materials.

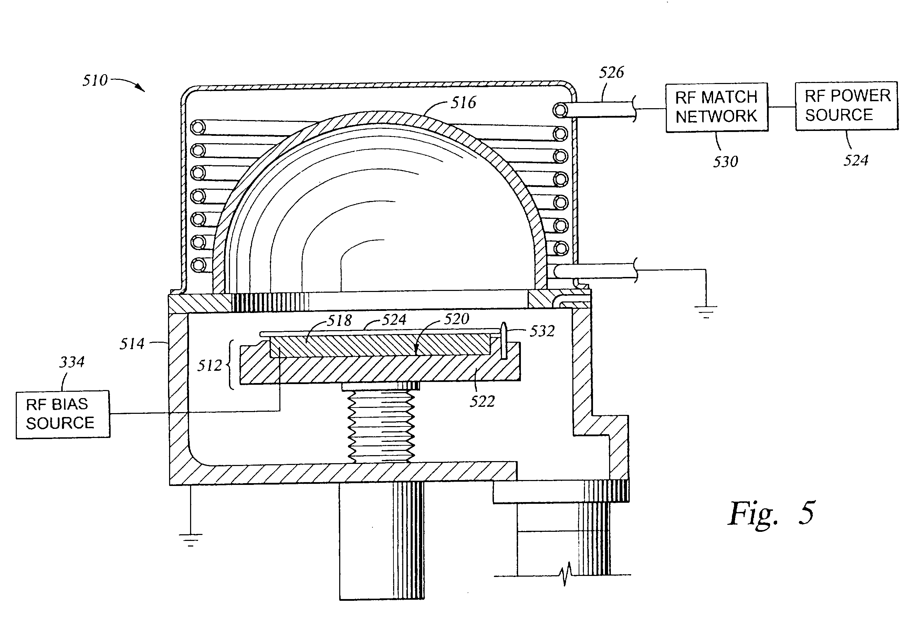

Third, an argon plasma cleaning (step 212) according to the present invention is performed on the patterned substrate to remove deposits from prior process steps. In the argon plasma step, deposits are sputtered by an argon plasma and removed from the apertures. The argon sputter process can be performed in a variety of chambers, but is preferably performed in a pre-clean chamber. Fourth, a hydrogen plasma pre-cleaning step according to the present invention is performed on the patterned substrate. The substrate is pre-cleaned using a hydrogen plasma (step 215) to reduce copper oxide to copper and to clean and stabilize the structure of the dielectric layer. Although the pre-cleaning step can be carried out in any typical plasma processing chamber, the pre-cleaning step is preferably carried out in a pre-clean chamber. The argon plasma etch and the hydrogen plasma pre-cleaning steps according to the invention are discussed in more detail with reference to a pre-clean chamber shown in Figure 5.

Next, a diffusion barrier layer, preferably tantalum nitride, is deposited (step 220) to prevent diffusion of silicon into an overlaying metal layer. The diffusion barrier layer also improves film adhesion between different films, such as a metal film and a silicon oxide film. The tantalum nitride layer is preferably deposited using a PVD chamber outfitted for reactive sputtering which is well known in the art. Preferably, the diffusion barrier layer has a film thickness between about 50 Å and about 200 Å.

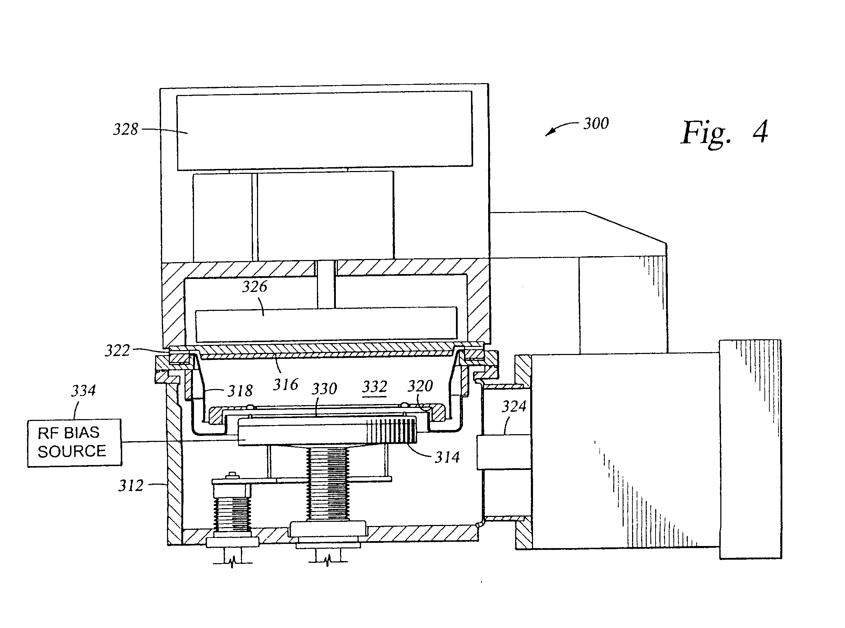

Figure 4 is a cross sectional view of a typical PVD chamber useful for depositing a barrier layer. The PVD chamber 310 generally includes a chamber enclosure 312, a substrate support member 314, a target 316, a shield 318, a clamp ring 320, a gas inlet 322, a gas exhaust 324, a magnet assembly 326, an RF plasma power source 328, and an RF bias source 334. During processing, a substrate 330 is placed on the substrate support member 314 and a processing gas is introduced through the gas inlet 322 disposed between the edge of the target and the top portion of the shield into a processing region 332 defined by the target 316, the substrate 330, and the shield 318. The RF plasma power source 328 supplies an RF power to the target to strike and maintain a plasma of the processing gas in the processing region 332 during processing while the RF bias source 334 supplies an RF bias to the substrate support member 314. The shield 318 is typically grounded during processing. During deposition, the ions in the plasma bombard the target to sputter material from the target surface. The sputtered material reacts with ions in the plasma and forms the desired film on the surface of the substrate. For deposition of a barrier film, such as tantalum/tantalum nitride, the processing gas typically comprises argon and nitrogen, wherein argon serves as the primary gas source for the plasma ions that bombard the target 316 and nitrogen primarily reacts with the sputtered atoms (tantalum) from the target 316 to form a tantulum/tantalum nitride film which is deposited onto the substrate 330. After deposition of the barrier film, the substrate is typically annealed at a temperature between about 300°C and about 500°C to improve the material properties of the deposited film.

Lastly, a metal layer, such as copper, is deposited over the diffusion barrier layer to complete the formation of the interconnect feature (step 225). Preferably, the metal layer is between about 6,000 Å and about 10,000 Å thick. The copper deposition can be carried out in a typical PVD chamber or a typical CVD chamber which are well known in the art. The above-described process may be repeated for multi-level integrated circuit structures.

According to the present invention, the patterned dielectric layer is pre-cleaned using an argon plasma and then a hydrogen plasma prior to the deposition of the tantalum nitride barrier layer. The pre-cleaning processes can be carried out in a variety of processing chambers, including a PVD chamber, a CVD chamber, an etch chamber and a pre-clean chamber. Preferably, the pre-cleaning process is carried out using a pre-clean chamber prior to the deposition of the tantalum nitride barrier layer. Although the invention is described using a pre-clean chamber, it is understood that the invention is applicable to a variety of processing chambers.

Figure 5 is a cross sectional view of a typical pre-clean chamber useful for the present invention. An example of a pre-clean chamber useful for the present invention is the Pre-Clean II Chamber available from Applied Materials, Inc., Santa Clara, California. Generally, the pre-clean chamber 510 has a substrate support member 512 disposed in a chamber enclosure 514 under a quartz dome 516. The substrate support member 512 typically includes a central pedestal plate 518 disposed within a recess 520 on an insulator plate 522, typically constructed of quartz, ceramic or the like. During processing, the substrate 524 is placed on the central pedestal plate 518 and contained thereon by locating pin 532. Preferably, an RF coil 526 is disposed outside of the quartz dome 516 and connected to an RF power source 524 to strike and maintain a plasma of the process gases within the chamber. Generally, a RF match network 530 is provided to match the RF power source 524 and the RF coil 526. Typically, the substrate support member 512 is connected to an RF bias source 528 that provides a bias to the substrate support member 512. The RF power source 524 preferably provides up to about 500W of 2 MHz RF power to the coil 526 and the RF bias source 528 preferably provides up to about 500W of 13.56 MHz RF bias to the substrate support member 512.

According to the invention, the patterned or etched substrate is preferably pre-cleaned using first an argon plasma and then a hydrogen plasma in the pre-clean chamber prior to the deposition of a barrier layer. Preferably, the substrate is transferred into the pre-clean chamber after the dielectric layer has been planarized and the openings of the interconnect features have been formed. The pattern etching of the substrate may be processed in another processing platform or system before the substrate is transferred to a processing platform or system having a pre-clean chamber. Once the substrate is positioned for processing in the pre-clean chamber, a processing gas comprising predominantly argon, *i.e.,* greater than about 50% argon by number of atoms, is introduced into the processing region at a pressure of preferably about 0.8 mtorr. A plasma of the argon gas is struck in the processing region to subject the substrate to an argon sputter cleaning environment. The argon plasma is preferably generated by applying between about 50 W and about 500 W of RF power from the RF power source 524 to the RF coil 526 and between about 50 W and about 500 W of RF bias from the RF bias source 528 to the substrate support member 512. The argon plasma is maintained for between about 10 seconds and about 300 seconds to provide sufficient cleaning time for the deposits that are not readily removed by a reactive hydrogen plasma. The argon plasma is preferably generated by about 300W RF power applied to the coil and about 300W RF bias applied to the substrate support member, and preferably is maintained for about 60 seconds.

Following the argon plasma, the chamber pressure is increased to about 80 mtorr, and a processing gas consisting essentially of hydrogen and helium, comprising between about 5% and about 100% hydrogen by number of atoms, is introduced into the processing region. Preferably, the processing gas comprises about 5% hydrogen and about 95% helium. A plasma of the hydrogen/helium gas is struck in the processing region to subject the substrate to a reactive hydrogen plasma environment. The hydrogen plasma is generated by applying between about 50 W and about 500 W power from the RF power source 524 to the RF coil 526 and between about 5 W and about 300 W of RF bias from the RF bias source 528 to the substrate support member 512. The hydrogen plasma is maintained for between about 10 seconds and about 300 seconds to reduce copper oxide to copper and to clean the substrate. The hydrogen plasma is preferably generated by about 450W RF power applied to the coil and about 10W RF bias applied to the substrate support member, and preferably is maintained for about 60 seconds. Once the pre-cleaning process is completed, the pre-clean chamber is evacuated to exhaust the processing gas and the reacted byproducts from the pre-cleaning process. The barrier layer is then deposited over the cleaned substrate, and the remaining processes outlined in Figure 3 are then carried out.

### II. Pre-Cleaning an Area of Metal in a Low-K Dielectric on a Semiconductor Workpiece

The pre-cleaning process is one segment of a sequence of process steps for forming a metal plug or via in a low-K, carbon-containing dielectric on a semiconductor workpiece. A low-K dielectric has a dielectric constant "K" that is less than 3.8, preferably less than or equal to 3.0. An example of a low-K, carbon-containing, silicon oxide dielectric and a process for forming it on a silicon wafer is described in commonly assigned U.S. patent application SN 09/247,381 filed 2/10/99 by *Cheung et al.,* the entire content of which is hereby incorporated by reference into this patent specification. This type of carbon-containing silicon oxide has a dielectric constant less than that of conventional, non-carbon-containing silicon dioxide because it incorporates carbon atoms in the silicon oxide material. The carbon atoms typically are incorporated in the silicon oxide in the form of C-H bonds or C-F bonds. To achieve a low dielectric constant K, the dielectric preferably has a carbon content of at least 1% by weight, more preferably at least 5%.

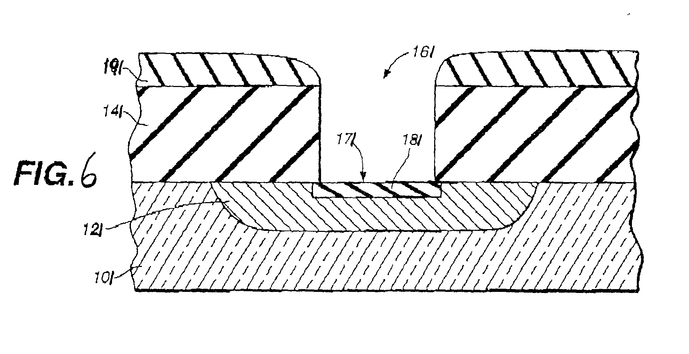

Figure 6 shows a conventional semiconductor workpiece or substrate 10 on which the processes of the invention may be performed. The substrate typically is a silicon wafer on which integrated circuits are to be formed or a glass substrate on which electronic video display devices and circuits are to be formed. The substrate is depicted as a silicon wafer in all of the following examples.

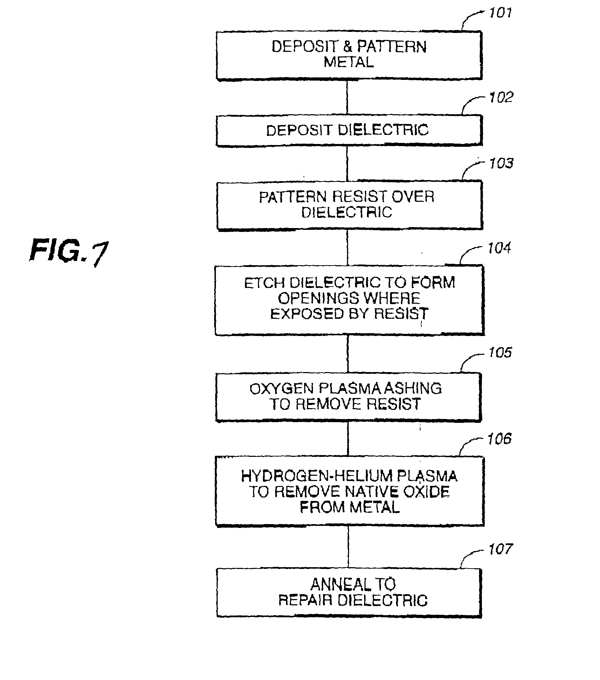

The workpiece or substrate 10 includes one or more regions 12 composed of a metal conductor such as copper or tungsten. The metal regions can be formed by any conventional metal deposition and patterning processes (Figure 7, Step 101).

A low-K, carbon-containing dielectric layer 14 overlies the metal regions. The dielectric 14 is patterned with a number of openings 16 so that each opening exposes an area 17 of one of the metal regions 12, this area 17 being termed the "contact area", "exposed area" or "exposed surface" of the metal region. (We define all portions of the metal regions 121 that are not covered by dielectric 141 as being "exposed" even though the exposed surface may be covered by thin layer of native oxide as a result of exposure of the metal to oxygen, such as oxygen in the ambient atmosphere.)

Each opening 161 subsequently will be filled with a metal material to form a "plug" or "via" that makes electrical contact with the underlying metal region 121.

The typical process for creating openings 161 in the dielectric is to deposit a blanket layer of dielectric 141 (Step 102), then employ a photo-lithographic process to form a pattern of photoresist 191 over all areas of the dielectric other than the areas where openings are desired (Step 103). A plasma etch process then etches openings 161 in all portions of the dielectric that are not covered by photoresist (Step 104).

If the workpiece is exposed to oxygen after the openings 161 are formed, the exposed surface of each contact area generally will oxidize to form a thin layer of "native oxide" 181. Such oxygen exposure may occur in an "ashing" process for removing photoresist 191 after etching the openings in the dielectric (Step 105), or it may occur if the workpiece is exposed to ambient atmosphere while it is transported between two process chambers. This native oxide must be removed or "cleaned" before depositing the metal plug in order to achieve good electrical contact between the plug and the contact area. The process of removing such native oxide (Step 106) is termed "pre-cleaning" because it precedes deposition of the metal plug.

In the invention, the pre-cleaning of the contact area 171 (Step 106) is performed by exposing the workpiece 101 to an atmosphere formed by plasma decomposition of a gas mixture that includes helium and at least one species of a hydrogen-containing gas. Although our invention is not limited to a specific theory of operation, we believe that the plasma dissociates the hydrogen-containing gas to produce hydrogen radicals and ions that migrate from the plasma to the semiconductor workpiece. Upon contact with the native oxide 18 on the workpiece, the hydrogen radicals and ions react with the oxygen component of the native oxide to form volatile hydroxyls and water vapor that are exhausted from the chamber by the exhaust pump, thereby removing the native oxide 18 from the surface of the metal contact areas 121.

To minimize damage to the low-K, carbon-containing dielectric, it is preferable to form the plasma by a method that minimizes electric fields at the workpiece position.

One suitable method of forming the plasma is in a conventional remote plasma source, which means that the plasma either is formed in a separate chamber from the vacuum chamber that holds the workpiece, or else the plasma is formed in a separate region of a common chamber such that the plasma body is a substantial distance from the workpiece. In either case, an exhaust pump causes radicals and ions produced by decomposition of gases in the plasma to flow from the plasma body to the workpiece. Conventional process chambers having remote plasma sources are described in commonly-assigned U.S. patents 5,346,579 to *Cook et al.* and 5,543,688 to *Morita,* the entire content of each of which is hereby incorporated by reference into this patent specification.

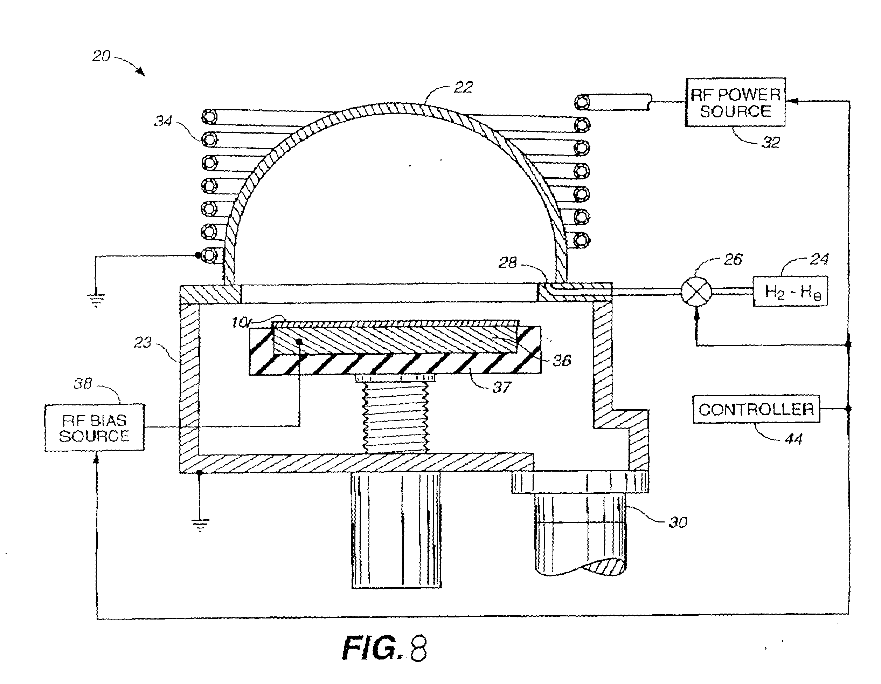

Alternatively, our currently preferred method of forming the plasma so as to avoid sputtering damage to the workpiece is in a plasma chamber having an inductively coupled plasma source, such as the commercially available pre-clean chamber 20 shown in Figure 8.

The upper portion of the chamber is bounded by an upper wall 22 composed of dielectric material, typically quartz, and the lower portion of the chamber is bounded by a lower wall 23 composed of either dielectric or conducting material, typically aluminum. The hydrogen-helium gas mixture described above flows from a gas supply tank 24 at a flow rate regulated by a flow controller 26, typically a mass flow controller, and then is injected into the upper portion of the chamber through one or more gas inlet ports 28. An exhaust pump, not shown, exhausts chamber gases through exhaust port 30 and regulates the chamber pressure.

A primary RF power supply 32 supplies RF electrical power to an induction coil 34 that encircles the dielectric upper chamber wall 22. The electrical power is inductively coupled from the coil to the gases in the upper portion of the chamber so as to excite the gases to a plasma state.

The workpiece or substrate 101 is mounted in the lower portion of the chamber on a pedestal or susceptor 36, typically composed of aluminum or titanium. All surfaces of the susceptor that are not covered by the substrate are covered by a dielectric 37, typically quartz.

A second RF power supply 38, also called a bias RF power supply, supplies RF power to the pedestal. The bias RF power supply can help ignite and sustain the plasma, and it can produce a DC bias voltage on the pedestal that in most cases is negative relative to the plasma body. The negative bias voltage accelerates ions from the plasma toward the susceptor.

Since RF bias power increases the risk of damage to the dielectric by ion bombardment, we prefer using the lowest possible RF bias power. We believe we can successfully remove native oxide from the metal 12 without any RF bias power applied to the pedestal. However, in the illustrated inductively-coupled plasma chamber, some RF bias power usually is required to initiate or "strike" the plasma. In addition, a small amount of RF bias power can ensure that changing process conditions do not extinguish the plasma. Therefore, in our preferred implementation we program the controller 44 to command the bias RF power supply 38 to initially apply to the pedestal 40 watts of RF power at a frequency of 13.56 MHz in order to initiate or strike the plasma, and to then reduce the bias RF power to 10 watts throughout the pre-cleaning process. At low power levels such as the preferred 10 watts, we find the DC bias voltage on the pedestal is close to zero, and even can be positive in the preferred chamber of Figure 8.

In a chamber having a remote plasma source, we do not believe there would be any need to apply RF bias power to the pedestal.

Our preferred hydrogen-containing gas is H₂. Alternative choices include NH₃ (ammonia) and SiH₄ (silane).

A preferred gas mixture is 5% H₂ and 95% He by molecular molar concentration, which is approximately the same concentration by gas volume. Since H₂ and He are diatomic and monatomic gases, respectively, this is equivalent to 10% H and 90% He by atomic molar concentration.

The pre-cleaning process is especially useful for cleaning metal regions 121 composed of copper, because copper oxide is readily reduced by hydrogen at temperatures below 100° C. Most other metals would require greater heating of the substrate in order to perform the reduction reaction. The feasibility of subjecting the substrate to the required temperature depends on whether the dielectric 141 and other structures on the substrate would be damaged.

The helium carrier gas advantageously enhances the dissociation of the hydrogen in the plasma. Because helium ions are very light, they will subject the dielectric 14 to little or no sputtering damage. In contrast, carrier gases composed of atomic species having a greater atomic mass, such as argon, would be more likely to damage the dielectric, as evidenced by the comparative test results described below. Therefore, to minimize sputtering of the dielectric, we recommend that the gas mixture does not include BCl₃, argon, or any compound of any element having an atomic mass greater than the atomic mass of argon.

The hydrogen-containing plasma is maintained as long as necessary to remove the native oxide 181. In tests processing 200 mm diameter silicon wafers in the illustrated inductively coupled plasma chamber, with 300 watts RF power applied to the induction coil, we found that 30 seconds was more than adequate to remove the thickest copper oxide film 181 we encountered. We found that either increasing the plasma cleaning time to 60 seconds, or increasing the RF power to 450 watts, slightly increased the damage to the dielectric, as evidenced by an increase in its dielectric constant. The test results are described below.

Other process parameters in our preferred embodiment for pre-cleaning a 200 mm silicon wafer include a 100 sccm flow rate for the H2-He gas mixture and a chamber pressure of 80 millitorr.

All process steps preferably are controlled by a programmable controller such as microcomputer 44 which controls the amount of power supplied by the RF power supplies 32, 38 and controls the flow rate of the hydrogen-helium gas mixture provided by the flow controller 26.

### Comparative Tests

Tests were conducted on the effect of the metal pre-cleaning process on the dielectric constant of a carbon-containing low-K dielectric film. To simplify the test, a metal film was not actually tested. Instead, a blanket layer of low-K dielectric was subjected to the same hydrogen-helium plasma process that would be used to clean a copper film. This test indicates whether the metal pre-cleaning process would damage the low-K dielectric, as evidenced by the measurement of the increase in the dielectric constant K after performing our pre-clean process. The pre-clean process was compared with an argon sputtering pre-clean process. Also tested was the performance of the process as a function of RF power, hydrogen concentration, and duration.

In the tests, the low-K dielectric film was deposited on 200 mm diameter silicon wafers in accordance with the dielectric deposition process described in the above-referenced patent application SN 09/247,381. This process deposits a dielectric having a dielectric constant K of about 2.70 to 2.75. The test data shown in Tables 1 and 2 shows the amount by which the tested pre-clean processes increased the dielectric constant above this value. The increase in dielectric constant indicates the degree of damage to the dielectric film.

The pre-clean process was performed in the previously described pre-clean chamber shown in Figure 8. In all cases the chamber pressure was 80 mTorr, the flow rate of the hydrogen-helium gas mixture was 100 sccm, the RF power applied to the induction coil was at a frequency of 2 MHz and the power level shown in Tables 1 and 2. Also, in all cases the pre-clean process was preceded by a de-gas step in which the wafer was maintained at 400° C for one minute to drive out moisture and oxygen that the dielectric may have been absorbed during prior exposure to atmosphere.

We also tested whether thermal annealing would repair damage to the dielectric film 14. After performing the pre-clean process, we annealed the dielectric film by heating the substrate to 400° C for 30 minutes in a vacuum environment (Step 107). Tables 1 and 2 show our measurement of the increase in dielectric constant before and after the annealing step.

**Table 1 -**

| **Effect of Pre-clean on Dielectric Constant: Without Plasma Ashing** | | | | | |
|---|---|---|---|---|---|
| Run | Gas | RF Power to Induction Coil | Duration | Increase in Dielectric Constant: Before Anneal | Increase in Dielectric Constant: After Anneal |
| 1 | Ar (Sputter) | 300 W (& 300 W bias) | 30 sec. | 0.16 | 0.21 |
| 2 | 5% H₂ / 95% He | 300 W | 30 sec. | 0.10 | 0.05 |
| 3 | 5% H2 / 95% He | 300 W | 60 sec. | 0.17 | 0.12 |
| 4 | 5% H₂ / 95% He | 300 W | 120 sec. | 0.23 | 0.19 |
| 5 | 5% H₂ / 95% He | 450 W | 60 sec. | 0.19 | 0.14 |
| 6 | 10% H₂ / 90% He | 300 W | 30 sec. | 0.22 | 0.19 |
| 7 | 10% H₂ / 90% He | 300 W | 60 sec. | 0.26 | 0.20 |
| 8 | 10% H₂ / 90% He | 450 W | 60 sec. | 0.30 | 0.20 |

Referring to Table 1, Run 1 shows that a conventional argon sputter cleaning process increased the dielectric constant by 0.16. In contrast, Run 2 shows that our H2-He reactive cleaning process inflicted less damage to the dielectric, as it increased the dielectric constant by only 0.10.

Table 1 also shows that a subsequent anneal step is surprisingly synergistic with our H₂-He process, in contrast with the detrimental effect of annealing after a conventional argon sputtering process. Referring to Run 1, annealing further exacerbated the increase in dielectric constant caused by argon sputtering. In contrast, Run 2 shows that the anneal step repaired the minor damage inflicted by our H₂-He pre-clean process by reducing the dielectric constant to a value only 0.05 greater than that before the pre-cleaning. Runs 3-8 also show that the annealing step reduced the dielectric constant, which indicates that the annealing repaired some of the damage to the dielectric film caused by the H₂-He plasma pre-cleaning process.

Therefore, after performing the H₂-He plasma pre-cleaning process (Step 106), it is highly beneficial to anneal the substrate at a sufficient temperature and duration to reduce the dielectric constant of the dielectric film (Step 107). The anneal temperature should be greater than 100° C, preferably at least 300° C, and most preferably in the range of 300° C to 450° C. If the annealing is performed in a conventional thermal anneal chamber - i.e., a chamber that heats the workpiece primarily by thermal conduction and convection rather than radiation - the workpiece typically should be annealed for at least five minutes, and more preferably 30 minutes. Alternatively, a radiant heating chamber, commonly called a rapid thermal processing chamber, can radiantly heat the surface of the workpiece to a much higher temperature for a much shorter duration.

Runs 3-8 show that increasing the hydrogen concentration, the RF power to the induction coil, or the duration of the pre-clean process increases the damage to the dielectric. Therefore, the process parameters of Run 2 are preferred.

Also tested were the effects of preceding the pre-clean process with a conventional oxygen plasma ashing process. As described earlier, plasma ashing is conventionally performed prior to metal pre-cleaning in order to remove various organic material from the surface of the dielectric. Such organic material may include photoresist on the top surface of the dielectric, a "passivation layer" deposited on the side walls of the via openings during the etching of the vias, and other organic byproducts of the etch process. In oxygen plasma ashing, the organic material is removed or "stripped" by exposing the workpiece to an atmosphere formed by plasma decomposition of oxygen, and optionally other gases. Preferred parameters of a conventional oxygen plasma ashing process for stripping photoresist after patterning of a silicon oxide dielectric are 500 to 1000 sccm oxygen gas flow rate, with no carrier gas, 15 mT chamber pressure, and 3000 watts of RF power at 2 MHz applied to the induction coil of an inductively-coupled plasma chamber like that shown in Figure 8. No bias RF power is used during the ashing process so as to avoid sputtering damage to the dielectric.

**Table 2 -**

| Effect of Pre-clean on Dielectric Constant: Preceded by Plasma Ashing | | | | | |
|---|---|---|---|---|---|
| Run | Gas | RF Power to Induction Coil | Duration | Increase in Dielectric Constant: Before Anneal | Increase in Dielectric Constant: After Anneal |
| 0 | None (ashing only) | 0 | 0 | 0.25 | 0.32 |
| 1 | Ar (Sputter) | 300 W (+ 300 W bias) | 30 sec. | 0.18 | 0.23 |
| 2 | 5% H₂ / 95% He | 300 W | 30 sec. | 0.14 | 0.16 |
| 3 | 5% H2 / 95% He | 300 W | 60 sec. | 0.16 | 0.19 |
| 4 | 5% H₂ / 95% He | 300 W | 120 sec. | 0.16 | 0.18 |
| 5 | 5% H2 / 95% He | 450 W | 60 sec. | 0.17 | 0.21 |
| 6 | 10% H₂ / 90% He | 300 W | 30 sec. | | 0.28 |
| 7 | 10% H₂ / 90% He | 300 W | 60 sec. | | 0.28 |
| 8 | 10% H₂ / 90% He | 450 W | 60 sec. | | 0.28 |

Table 2 shows the test results when wafers were subjected to the just described oxygen plasma ashing process prior to the previously described de-gas and pre-clean processes. Except for the ashing process, the test conditions were identical to those of the tests reported in Table 1.

Run 0 represents the substrate following the oxygen plasma ashing process, prior to the de-gas process and the pre-cleaning process. The increase in dielectric constant shown in Table 2, Run 0 is greater than the increase shown in Table 1, Run 1. This result indicates that the oxygen plasma ashing process damaged the dielectric even more than the argon sputtering process reported in Table 1, Run 1.

In Table 2 the dielectric constants for Runs 1-8 are lower than the dielectric constants in the corresponding column for Run 0. This result indicates that both the argon sputter pre-cleaning (Run 1) and the hydrogen-helium reactive plasma cleaning of our invention (Runs 2-8) repair some of the damage to the dielectric caused by the ashing (Run 0). It is surprising that these pre-cleaning processes, which by themselves cause damage to the dielectric as shown in Table 1, produce the opposite effect - repairing damage to the dielectric - when performed after plasma ashing.

The best results were achieved with Run 2, the embodiment of our hydrogen-helium reactive cleaning process having the lowest tested values for hydrogen concentration, RF power, and process duration. This is the same set of process conditions that minimized the damage to the dielectric in the tests without ashing reported in Table 1. In contrast to the tests without ashing reported in Table 1, Table 2 shows that when oxygen plasma ashing is performed before pre-cleaning, thermal annealing does not help repair the damage to the dielectric. In every test reported in Table 2, thermal annealing worsened the damage to the dielectric, as evidenced by an increase in the measured dielectric constant after annealing. Therefore, after pre-cleaning wafers that have been subjected to oxygen plasma ashing, it is preferable to omit thermal annealing.

The results (Runs 6-8) using 10% hydrogen by molecular molar concentration (20% by atomic molar concentration) are significantly worse than those for 5% hydrogen (Runs 2-5). We believe the higher hydrogen concentration resulted in positively charged hydrogen ions being implanted into the plasma ashed films, thereby shifting the flat-band voltage. This shift in flat-band voltage did not appear to occur in the tests performed with 5% H2 / 95% He (Runs 2-5). Therefore, a H₂-He gas mixture having a hydrogen content of 5% or less by molecular molar concentration (10% or less by atomic molar concentration) is preferred when performing the pre-clean process on a dielectric film that has been subjected to oxygen plasma ashing.

In summary, the test results for processes that do not employ plasma ashing show that our preferred H2-He reactive cleaning process (Table 1, Run 2) produces essentially no damage to the low-K, carbon-containing dielectric. For process that do employ oxygen plasma ashing, our preferred H2-He reactive cleaning process (Table 2, Run 2) surprisingly repairs much of the damage to the dielectric caused by the ashing process.

While the foregoing is directed to the preferred embodiment of the present invention, other and further embodiments of the invention may be devised without departing from the basic scope thereof. The scope of the invention is determined by the claims which follow.

## Claims

1. A method for improving metal deposition on a patterned dielectric layer, comprising:
(a) cleaning the patterned dielectric layer in a processing chamber with a first plasma comprising predominantly argon; and
(b) cleaning the patterned dielectric layer in the processing chamber with a second plasma consisting essentially of hydrogen and helium.

2. A method as claimed in claim 1, wherein the processing chamber is a pre-clean chamber.

3. A method as claimed in claim 1 or claim 2, wherein the first plasma consists essentially of argon.

4. A method as claimed in any of claims 1 to 3, wherein the second plasma consists essentially of from about 5% to about 100% of hydrogen by number of atoms and from about 0% to about 95% of helium by number of atoms.

5. A method as claimed in any of claims 1 to 4, further comprising depositing a metal on the patterned dielectric layer after exposing the dielectric layer to the first plasma and the second plasma.

6. A method for improving metal deposition on a patterned dielectric layer on a substrate, comprising:
(a) cleaning the patterned dielectric layer in a processing chamber with a first plasma consisting essentially of argon, wherein the first plasma is generated by supplying RF power to a coil surrounding the processing chamber and supplying RF bias to a substrate support member supporting the substrate;
(b) cleaning the patterned dielectric layer in the processing chamber with a second plasma consisting essentially of hydrogen and helium, wherein the second plasma is generated by increasing the supply of RF power to the coil surrounding the processing chamber and reducing the supply of RF bias to the substrate support member supporting the substrate;
(c) depositing a barrier layer on the patterned dielectric layer after exposing the dielectric layer to the first plasma and the second plasma; and
(d) depositing a metal on the barrier layer.

7. A method as claimed in claim 6, wherein the processing chamber is a pre-clean chamber.

8. A method as claimed in claim 6 or claim 7, wherein the second plasma consists essentially of from about 5% to about 100% of hydrogen by number of atoms and from about 0% to about 95% of helium by number of atoms.

9. A method as claimed in any of claims 6 to 8, wherein the second plasma consists essentially of about 5% of hydrogen by number of atoms and about 95% of helium by number of atoms.

10. A method as claimed in any of claims 6 to 9, wherein the first plasma is generated with about 300 W of RF power supplied to the coil and about 300 W of RF bias supplied to the substrate support member, and the second plasma is generated with about 450W of RF power supplied to the coil and about 10 W of RF bias supplied to the substrate support member.

11. A method as claimed in any of claims 6 to 10, wherein each plasma is maintained in the processing chamber for about 60 seconds.

12. A method as claimed in any of claims 6 to 11, wherein the first plasma is generated at a pressure in the processing chamber of about 0.8 mtorr, and the second plasma is generated at a pressure in the processing chamber of about 80 mtorr.

13. A method of cleaning an area of a metal conductor exposed in at least one opening in a low-K dielectric on a semiconductor workpiece, comprising the steps of:
(a) providing a semiconductor workpiece that includes a dielectric having at least one opening exposing an area of a metal conductor, wherein the dielectric has a dielectric constant less than or equal to 3.0; and
(b) exposing the workpiece to an atmosphere produced by plasma decomposition of a gas mixture, wherein the gas mixture includes helium and at least one hydrogen-containing gas species.

14. A method of cleaning an area of a metal conductor exposed in at least one opening in a carbon-containing dielectric on a semiconductor workpiece, comprising the steps of:
(a) providing a semiconductor workpiece that includes a carbon-containing dielectric overlying a metal conductor, wherein the dielectric includes at least one opening exposing an area of the metal conductor; and
(b) exposing the workpiece to an atmosphere produced by plasma decomposition of a gas mixture, wherein the gas mixture includes helium and at least one hydrogen-containing gas species.

15. A method as claimed in claim 14, wherein the dielectric has a dielectric constant less than 3.8.

16. A method as claimed in claim 14, wherein the dielectric has a dielectric constant less than or equal to 3.0.

17. A method as claimed in any of claims 14 to 16, wherein the dielectric is an oxide of silicon having a chemical structure that incorporates carbon.

18. A method as claimed in any of claims 14 to 17, wherein the dielectric contains at least five percent carbon by weight.

19. A method as claimed in any of claims 14 to 18, further comprising the step of:
subsequent to the exposing step, annealing the workpiece at a temperature and for a duration sufficient to reduce the dielectric constant of the dielectric relative to the value of said dielectric constant after the providing step and prior to the annealing step.

20. A method of repairing damage to a carbon-containing dielectric on a semiconductor workpiece caused by a plasma process for stripping resist from a surface of the dielectric, comprising the steps of:
(a) providing a semiconductor workpiece that includes a carbon-containing dielectric and an organic resist material overlying portions of the dielectric;
(b) removing the resist material by exposing the workpiece to a first atmosphere produced by plasma decomposition of at least one gas, wherein the or at least one gas includes oxygen; and
(c) subsequently exposing the workpiece to a second atmosphere produced by plasma decomposition of a gas mixture, wherein the gas mixture includes helium and at least one hydrogen-containing gas species.

21. A method as claimed n claim 20, wherein:
(a) the workpiece further comprises a metal conductor underlying the dielectric;
(b) the dielectric includes at least one opening exposing an area of the metal conductor; and
(c) the step of exposing the workpiece to the second atmosphere is performed for a time long enough to remove substantially all native oxide from the exposed area of the metal conductor.

22. A method as claimed in claim 20 or claim 21, wherein the dielectric has a dielectric constant less than 3.8.

23. A method as claimed in any of claims 20 to 22, wherein the dielectric is an oxide of silicon having a chemical structure that incorporates carbon.

24. A method as claimed in any of claims 20 to 23, wherein the dielectric contains at least five percent carbon by weight.

25. A method of cleaning an exposed surface of a metal conductor on a semiconductor workpiece, comprising the steps of:
(a) positioning within a vacuum chamber a semiconductor workpiece that includes a metal conductor having an exposed surface; and
(b) while the workpiece is within the vacuum chamber, providing within the vacuum chamber an atmosphere produced by plasma decomposition of a gas mixture, wherein the gas mixture includes helium and at least one hydrogen-containing gas species.

26. A method of cleaning an area of a metal conductor exposed in at least one opening in a dielectric on a semiconductor workpiece, comprising the steps of:
(a) providing a semiconductor workpiece that includes a dielectric having at least one opening exposing an area of a metal conductor;
(b) exposing the workpiece to an atmosphere produced by plasma decomposition of a gas mixture, wherein the gas mixture includes helium and at least one hydrogen-containing gas species; and
(c) subsequent to the exposing step, annealing the workpiece at a temperature and for a duration sufficient to reduce the dielectric constant of the dielectric relative to the value of said dielectric constant after the providing step and prior to the annealing step.

27. A method as claimed in claim 26, wherein said temperature is at least 300°C.
